(19) Europäisches Patentamt / European Patent Office / Office européen des brevets

(11) **EP 4 455 314 A1**

(12) **EUROPEAN PATENT APPLICATION**
published in accordance with Art. 153(4) EPC

(43) Date of publication:
**30.10.2024 Bulletin 2024/44**

(21) Application number: **22911886.4**

(22) Date of filing: **20.12.2022**

(51) International Patent Classification (IPC):
*C21D 8/12* [(2006.01)]   *C22C 38/34* [(2006.01)]
*B23K 26/364* [(2014.01)]   *H01F 1/147* [(2006.01)]

(52) Cooperative Patent Classification (CPC):
**C22C 38/34; B23K 26/364; C21D 1/74;**
**C21D 6/002; C21D 6/005; C21D 6/008; C21D 8/12;**
**C21D 8/1222; C21D 8/1233; C21D 8/1255;**
**C21D 8/1261; C21D 8/1272; C21D 8/1283;**
**C21D 9/46; C21D 10/005;**          (Cont.)

(86) International application number:
**PCT/KR2022/020884**

(87) International publication number:
**WO 2023/121253 (29.06.2023 Gazette 2023/26)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **21.12.2021 KR 20210184135**

(71) Applicant: POSCO Co., Ltd
**Pohang-si, Gyeongsangbuk-do 37859 (KR)**

(72) Inventors:
• KWON, Ohyeoul
  **Pohang-si, Gyeongsangbuk-do 37859 (KR)**
• KIM, Woosin
  **Pohang-si, Gyeongsangbuk-do 37859 (KR)**
• HAN, Kyuseok
  **Pohang-si, Gyeongsangbuk-do 37859 (KR)**

(74) Representative: **Meissner Bolte Partnerschaft**
**mbB**
**Patentanwälte Rechtsanwälte**
**Postfach 86 06 24**
**81633 München (DE)**

(54) **GRAIN-ORIENTED ELECTRICAL STEEL SHEET AND METHOD FOR MAGNETIC-DOMAIN-REFINEMENT THEREOF**

(57) According to an exemplary embodiment of the present invention, a grain oriented electrical sheet includes: a plurality of deformed parts formed on a surface of the electrical sheet along a rolling direction, in which an interval between the deformed parts is changed over an entire length of the sheet in response to an index Ks of sensitivity calculated by Equation 1 below, and at least two areas having a different interval between the deformed parts exist.

[Equation 1]

$$Ks = (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

FIG. 1

**(Cont. next page)**

(52) Cooperative Patent Classification (CPC): (Cont.)
   **C22C 38/00; C22C 38/002; C22C 38/008;**
   **C22C 38/02; C22C 38/04; C22C 38/06;**
   **C22C 38/24; C22C 38/26; C22C 38/28;**
   **C22C 38/60; H01F 1/147; H01F 1/16; H01F 1/18**

**Description**

**[Technical Field]**

The present invention relates to a grain oriented electrical sheet and a method for refining magnetic domains therein. More particularly, the present invention relates to a grain oriented electrical sheet with excellent core loss in a magnetic flux density of a transformer operating section and a method for refining magnetic domains therein.

**[Background Art]**

A grain oriented electrical sheet is used as an iron core material for a transformer using electromagnetic induction, and the transformer is used in 50/60Hz alternating current, and may maximize the efficiency of the transformer by reducing no-load loss.

In order to reduce the no-load loss of the transformer, it is preferable to use an electrical sheet with excellent core loss in a magnetic flux density of an operating section of the transformer.

The grain oriented electrical sheet contains a large amount of Si, and is a functional sheet in which a texture of secondary recrystallized grains is oriented in the same Goss orientation ({110}<001 >) as a rolling direction through a melting process, a casting process, a hot rolling process, a hot rolled sheet annealing process, a cold rolling process, a primary recrystallization annealing process, a high temperature annealing process, and the like.

The magnetization characteristics of this grain oriented electrical sheet are microscopically determined by the ease of magnetization that occurs during movement and rotation of magnetic domains, and specifically determined by the form of 180° basic magnetic domains present in the secondary recrystallized grains of the product sheet.

The technology of refining magnetic domains in a grain oriented electrical sheet forms a free surface by forming grooves on a surface of the sheet through methods such as laser, plasma, and etching, and when tension is applied to the free surface in a rolling direction by further forming an insulating coating layer on the surface of the sheet, generates a magnetostatic effect of reducing magnetostatic energy due to the formation of the grooves. As a result, core loss characteristics are improved by reducing a 180° magnetic domain width in a secondary grain when a magnetic field is applied in order to minimize the magnetostatic effect.

For this reason, the grain oriented electrical sheet subjected to magnetic domain refinement treatment has improved core loss characteristics and is widely used as an iron core material for a transformer.

In this way, the technology of refining magnetic domains forms grooves on the surface of the sheet to obtain the magnetostatic effect by the free surface. However, the magnetostatic effect is determined by an orientation ratio of the Goss texture and a size of the secondary recrystallization when depths of the grooves are the same, and the orientation ratio of the Goss texture and the size of the secondary recrystallization change according to manufacturing process conditions of the electrical sheet.

In addition, in the process of manufacturing the electrical sheet, the final high-temperature annealing that forms the secondary recrystallization is often performed in a batch furnace in a coiled state. Since these coils are large in size, depending on the locations of the coils, that is, the inside, middle, and surface, the final high-temperature annealing conditions are different. Therefore, after the final high-temperature annealing is performed, a difference in direction and size of secondary recrystallized grains inevitably occurs depending on the location of the final coil product.

Therefore, since the difference in the size and orientation of the secondary recrystallized grain according to the width/length direction of the coil shows a change in core loss value according to a change in scan line intervals and angles of grooves even under the same groove depth condition when the groove is formed after or before the secondary recrystallization, it is necessary to form the grooves at different scan line intervals and angles in the transverse direction of the sheet.

**[Disclosure]**

**[Technical Problem]**

The present invention has been made in an effort to provide a grain oriented electrical sheet and a method for refining magnetic domains therein. Specifically, the present invention has been made in an effort to provide a grain oriented electrical sheet and a method for refining magnetic domains therein having advantages of increasing a core loss improvement rate by adjusting laser irradiation conditions for magnetic domain refinement according to a size of secondary recrystallization and orientation characteristics of the secondary recrystallized grain.

**[Technical Solution]**

An exemplary embodiment of the present invention provides a grain oriented electrical sheet including: a plurality of deformed parts formed on a surface of the electrical sheet along a rolling direction, in which an interval between the deformed parts may be changed over an entire length of the sheet in response to an index Ks of sensitivity calculated by Equation 1 below, and there may be at least two areas having a different interval between the deformed parts.

[Equation 1]

$$Ks = (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

The index Ks of sensitivity and the interval ($D_G$, mm) between the deformed parts may satisfy Equation 2 below.

[Equation 2]

$$(0.20 \times Ks) + 1.0 \leq D_G \leq (0.36 \times Ks) + 4.3$$

By dividing sections in a transverse direction of the sheet, the interval between the deformed parts that are different for each section may be formed according to the index Ks of sensitivity for each section.

By dividing sections in a rolling direction of the sheet, the interval between the deformed parts that are different for each section may be formed according to the index Ks of sensitivity for each section.

Another embodiment of the present invention provides a grain oriented electrical sheet including: a plurality of deformed parts formed on a surface of the electrical sheet along a rolling direction, in which angles of the deformed part and a rolling vertical direction may be changed over an entire length of the sheet in response to an index Ks of sensitivity calculated by Equation 1 below, and there may be at least two areas having different angles of the deformed part and the rolling vertical direction.

[Equation 1]

$$Ks = (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

The index Ks of sensitivity and the angles ($A_G$, °) of the deformed part and the vertical direction of rolling may satisfy Equation 3 below.

[Equation 3]

$$(-0.45 \times Ks) + 0.8 \leq |A_G| \leq (-0.25 \times Ks) + 6.5$$

by dividing sections in a transverse direction of the sheet, the angles of the deformed part and the rolling vertical direction that are different for each section may be formed according to the index Ks of sensitivity for each section.

by dividing sections in a rolling direction of the sheet, the angles of the deformed part and the rolling vertical direction that are different for each section may be formed according to the index Ks of sensitivity for each section.

The deformed part may include a temporary magnetic domain deformed part, a permanent magnetic domain deformed part, or a combination thereof.

The deformed part may include the permanent magnetic domain deformed part, and a depth of the permanent magnetic domain deformed part may be 10 to 30 $\mu$m.

Yet another embodiment of the present invention provides a method for refining magnetic domains in a grain oriented electrical sheet including: measuring a particle size of grain and magnetic flux density of the sheet; calculating an index Ks of sensitivity of Equation 1 below based on the measured particle size of grain and magnetic flux density value; and forming a deformed part by determining an interval between the deformed parts in response to the index Ks of sensitivity, in which the deformed part may be formed so that there are at least two areas in which an interval between the deformed parts is different. The deformed part may be formed so that there are at least two areas in which an interval between the deformed parts is different

[Equation 1]

$$Ks= (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

The index Ks of sensitivity and the interval ($D_G$, mm) between the deformed parts may satisfy Equation 2 below.

[Equation 2]

$$(0.20 \times Ks) + 1.0 \leq D_G \leq (0.36 \times Ks) + 4.3$$

Yet another embodiment of the present invention provides a method for refining magnetic domains in a grain oriented electrical sheet includes: measuring a particle size of grain and magnetic flux density of the sheet; calculating an index Ks of sensitivity of Equation 1 below based on the measured particle size of grain and magnetic flux density value; and forming a deformed part by determining angles of the deformed part and a rolling vertical direction in response to the index Ks of sensitivity, in which the deformed part may be formed so that there are at least two areas in which the angles of the deformed part and the rolling vertical direction are different.

[Equation 1]

$$Ks= (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

The index Ks of sensitivity and the angles ($A_G$, °) of the deformed part and the vertical direction of rolling may satisfy Equation 3 below.

[Equation 3]

$$(-0.45 \times Ks) + 0.8 \leq |A_G| \leq (-0.25 \times Ks) + 6.5$$

The particle size of grain of the sheet may be measured by applying magnetic force to the surface of the sheet to magnetize the sheet, detecting stray field formed by a grain boundary, and calculating the detected stray field to measure the particle size of grain.

The magnetic flux density of the sheet may be measured by changing the magnetic flux density in the transverse and longitudinal directions of the sheet through a continuous magnetic flux density meter.

The forming of the deformed part may include removing a coating solution for preventing surface etching by irradiating at least one of laser, electron beam, and plasma to the sheet; etching using an acid; or colliding particles.

The forming of the deformed part may include irradiating the sheet with laser to form a permanent magnetic domain deformed part or a temporary magnetic domain deformed part.

The grain oriented electrical sheet according to an exemplary embodiment of the present invention is an electrical sheet that includes 2.0 to 6.5 wt% of Si and the balance Fe, including other unavoidable impurities and has a Forsterite layer formed on a surface thereof by final high-temperature annealing and secondary recrystallization formed therein, in which the sheet may have a core loss index Ks of sensitivity value of 0.9 to 3.2 determined according to the following equation 1 based on the size of the secondary recrystallization and the magnetic flux density value, and a groove with a depth of 10 to 35 $\mu$m may be formed on the surface of the sheet by irradiating a laser in a direction crossing a rolling direction.

$$0.9 \leq (0.7Ds+0.3B)/10 \leq 3.2 \text{ -------------- 1}$$

(Where Ds: size of secondary recrystallization, B: magnetic flux density of sheet where secondary recrystallization is completed)

Grooves formed crossing the rolling direction may be dotted continuous or discontinuous grooves. In addition, the grooves formed crossing the rolling direction may be linear grooves formed continuously or discontinuously, and the linear grooves may be formed by being divided into at least two or more in the transverse direction of the sheet.

The dotted or linear groove may have an irradiation interval of 2.0 to 4.5 mm and an irradiation angle of 0 to 5°.

The dotted or linear groove may be formed by using any one of nanosecond, picosecond, or femtosecond laser as a pulse laser, and at a scanning speed of up to 50 m/s or less.

The sheet may further include, by wt%, 0.10% or less of C (excluding 0%), 0.005 to 1.0% of Mn, 0.05% or less of Nb+V+Ti (excluding 0%), 0.8% or less of Cr+Sn (excluding 0%), 3.0% or less of Al (excluding 0%), 0.09% or less of P+S (excluding 0%), and 0.5% or less (excluding 0%) of a total amount of rare earth elements and other impurities while satisfying the equation Sn% + Sb% - 0.7 Cr % $\leq$ 0.07.

The method for refining magnetic domains in a grain oriented electrical sheet according to the exemplary embodiment of the present invention includes a step of preparing a cold-rolled sheet by heating a slab made of 2.0 to 6.5 wt% of Si, other unavoidable impurities, and the balance Fe and then performing hot rolling and cold rolling on the slab; a decarburizing and/or nitriding step (or primary recrystallization step) of forming an oxide layer on a surface of the cold-rolled sheet by controlling a dew point temperature of atmospheric gas to 40 to 70°C and an $Fe_2SiO_4/SiO_2$ ratio to 0.5 to 3.0 at a temperature of 700 to 900°C; a step of applying an annealing separator containing MgO to the surface of the sheet; a final high-temperature annealing step (or secondary recrystallization annealing step) of forming a Forsterite layer on a surface of the sheet and forming the secondary recrystallization on an inside of the sheet; a step of calculating an index Ks of sensitivity value defined by the following Equation 1 by measuring the size of the secondary recrystallization and the magnetic flux density with respect to the sheet on which the secondary recrystallization is formed; a step of forming deformed parts by determining an interval between the deformed parts corresponding to the index Ks of sensitivity; and a step of insulation coating the sheet, on which grooves are formed, with a single or complex insulating coating solution of colloidal silica and metal phosphate.

[Equation 1]

$$Ks= (0.7 \times Ds+0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

The grooves may be formed in the step of forming the deformed parts, and the formed grooves may have a dotted continuous or discontinuous form.

The grooves formed in the step of forming the deformed parts may continuously or discontinuously form linear grooves, and the linear grooves may be formed by being divided into at least two or more in the transverse direction of the sheet. The dotted or linear grooves formed in the step of forming the deformed parts may have an irradiation interval of 2.0 to 4.5 mm and an irradiation angle of 0 to 5°.

In the step of forming the deformed parts, a laser may be irradiated, and the laser may be a pulse laser with an output of 30W or more, and any one of nanosecond, picosecond, and femtosecond lasers may be used.

A scanning speed of such a laser may be up to 50 m/s or less.

At least one intermediate step of a flattening annealing step, a first insulation coating step, or a secondary recrystallization completion step in which only the form is corrected may be further provided between the step of forming the deformed parts and the step of performing the insulation coating.

The sheet used in the method for refining magnetic domains in a grain oriented electrical sheet according to an embodiment of the present invention may further include, by wt%, 0.10% or less of C (excluding 0%), 0.005 to 1.0% of Mn, 0.05% or less of Nb+V+Ti (excluding 0%), 0.8% or less of Cr+Sn (excluding 0%), 3.0% or less of Al (excluding 0%), 0.09% or less of P+S (excluding 0%), and 0.5% or less (excluding 0%) of a total amount of rare earth elements and other impurities while satisfying the equation Sn% + Sb% - 0.7 Cr % $\leq$ 0.07.

**[Advantageous Effects]**

According to an embodiment of the present invention, it is possible to secure a high core loss improvement effect by adjusting laser scanning conditions to form linear grooves on a surface of a final high-temperature annealed sheet and by deriving an index of sensitivity on core loss based on a size and a degree of integration of a texture of the secondary recrystallization and a magnetic flux density value to control a laser irradiation interval and irradiation angle for the sheet within an optimal range of sensitivity on core loss.

In addition, according to the method for refining grain oriented electrical sheet of the present invention, it is possible to manufacture a grain oriented electrical sheet with excellent core loss improvement characteristics by controlling an irradiation interval and angle according to a size of secondary recrystallized grain and a magnetic flux density value in longitudinal and transverse directions of the sheet after final high-temperature annealing.

[Description of the Drawings]

FIG. 1 is a schematic diagram of a rolling surface (ND surface) of a grain oriented electrical sheet according to an exemplary embodiment of the present invention.

FIG. 2 is a schematic diagram of a rolling surface (ND surface) of a grain oriented electrical sheet according to another exemplary embodiment of the present invention.

FIG. 3 is a schematic diagram of a rolling surface (ND surface) of a grain oriented electrical sheet according to still another exemplary embodiment of the present invention.

FIG. 4 is a schematic diagram of a rolling surface (ND surface) of a grain oriented electrical sheet according to another exemplary embodiment of the present invention.

FIG. 5 is a schematic diagram of a rolling surface (ND surface) of a grain oriented electrical sheet according to another exemplary embodiment of the present invention.

FIG. 6 is a schematic diagram of a rolling surface (ND surface) of a grain oriented electrical sheet according to another exemplary embodiment of the present invention.

FIG. 7 is a schematic diagram of a rolling surface (ND surface) of a grain oriented electrical sheet according to another exemplary embodiment of the present invention.

FIG. 8 is a schematic diagram of a rolling surface (ND surface) of a grain oriented electrical sheet according to another exemplary embodiment of the present invention.

FIGS. 9 and 10 are schematic diagrams illustrating a method for measuring a grain size according to an embodiment of the present invention.

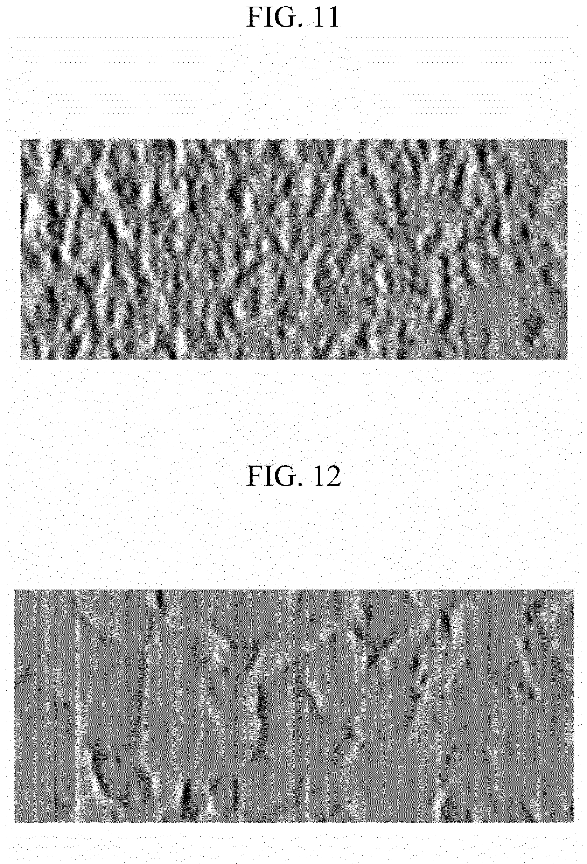

FIGS. 11 and 12 are results of measuring the grain size by the method according to an embodiment of the present invention

[Mode for Invention]

The terms first, second, third, and the like are used to describe, but are not limited to, various parts, components, areas, layers and/or sections. These terms are used only to distinguish a part, component, region, layer, or section from other parts, components, regions, layers, or sections. Accordingly, a first part, a component, an area, a layer, or a section described below may be referred to as a second part, a component, a region, a layer, or a section without departing from the scope of the present disclosure.

Terminologies used herein are to mention only a specific example, and do not to limit the present invention. Singular forms used herein include plural forms as long as phrases do not clearly indicate an opposite meaning. A term "including" used in the present specification concretely indicates specific properties, regions, integer numbers, steps, operations, elements, and/or components, and is not to exclude presence or addition of other properties, regions, integer numbers, steps, operations, elements, and/or components.

When a part is referred to as being "above" or "on" other parts, it may be directly above or on other parts, or other parts may be included in between. In contrast, when a part is referred to as being "directly above" another part, no other part is involved in between.

All terms including technical terms and scientific terms used herein have the same meaning as the meaning generally understood by those skilled in the art to which the present invention pertains unless defined otherwise. All terms including technical terms and scientific terms used herein have the same meaning as the meaning generally understood by those skilled in the art to which the present invention pertains unless defined otherwise.

Hereinafter, an exemplary embodiment of the present invention will be described in detail so that a person of ordinary skill in the art to which the present invention pertains can easily implement the present invention. As those skilled in the art would realize, the described embodiments may be modified in various different ways, all without departing from the spirit or scope of the present invention.

An exemplary embodiment of the present invention is to improve magnetism by adjusting an interval between deformed parts and/or angles of the deformed part and a rolling vertical direction in response to an index Ks of sensitivity calculated by a particle size of grain and a magnetic flux density of a sheet.

In the case of the grain oriented electrical sheet, the manufacturing process is very complicated, and there are various factors that control the particle size of grain and the magnetic flux density. Ideally, it is preferable to form grains of the same grain size over an entire length of the grain oriented electrical sheet and to control the magnetic flux density equally, but in reality, there is a considerable deviation in the particle size of grain and the magnetic flux density in a transverse direction (TD direction) and rolling direction (RD direction) of the sheet.

Conventionally, despite the fact that the deviation in the particle size of grain exists in reality, the deformed parts having the same interval are mechanically applied. However, according to the exemplary embodiment of the present invention, by variously changing the interval between the deformed parts and/or the angles of the deformed part and the rolling vertical direction in response to the index Ks of sensitivity calculated from the particle size of grain and the magnetic flux density, even if there is the deviation in the particle size of grain and the magnetic flux density, the magnetism of the electrical sheet are comprehensively improved.

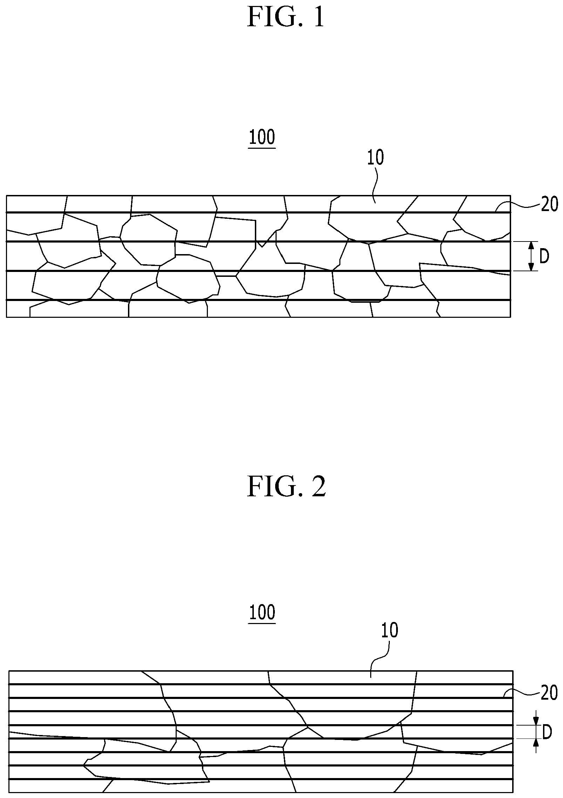

FIGS. 1 to 3 illustrate schematic diagrams of a grain oriented electrical sheet 100 subjected to magnetic domain refinement treatment according to an embodiment of the present invention.

In an exemplary embodiment of the present invention, a plurality of deformed parts is formed on a surface of the electrical sheet 100 along a rolling direction, in which an interval between the deformed parts may be changed over an entire length of the sheet in response to an index Ks of sensitivity calculated by Equation 1 below, and there are at least two areas having a different interval $D_G$ between the deformed parts.

$$[\text{Equation 1}]$$

$$Ks= (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

As illustrated in FIGS. 1 and 2, in an exemplary embodiment of the present invention, assuming that the magnetic flux density is the same, as in FIG. 1, when the particle size of grain is relatively small, the interval $D_G$ between the deformed parts is formed relatively wide. In addition, when the particle size of grain is relatively large as illustrated in FIG. 2 within the same sheet, the interval $D_G$ between the deformed parts is formed relatively narrow.

When the particle size of grain changes, a difference in internal structure called a magnetic domain occurs because the magnetic stability condition inside the grain changes. In other words, in the same Goss orientation, when the particle size of grain is large, clusters with similar magnetic domains are located large, and when the particle size of grain is small, clusters with similar magnetic domains are located small.

On the other hand, when the particle size of grain is relatively small, there is no problem in performing domain refinement with a relatively large interval $D_G$ between the deformed parts, but when the particle size of grain is relatively large, it is necessary to make the interval $D_G$ small. Despite the small particle size of grain, when the magnetic domain refinement is performed with a small interval $D_G$ between the deformed parts, many magnetic domains unfavorable to magnetization are generated around a boundary, which may cause core loss to deteriorate. Therefore, the core loss may be further improved by changing the interval between the deformed parts corresponding to each particle size of grain.

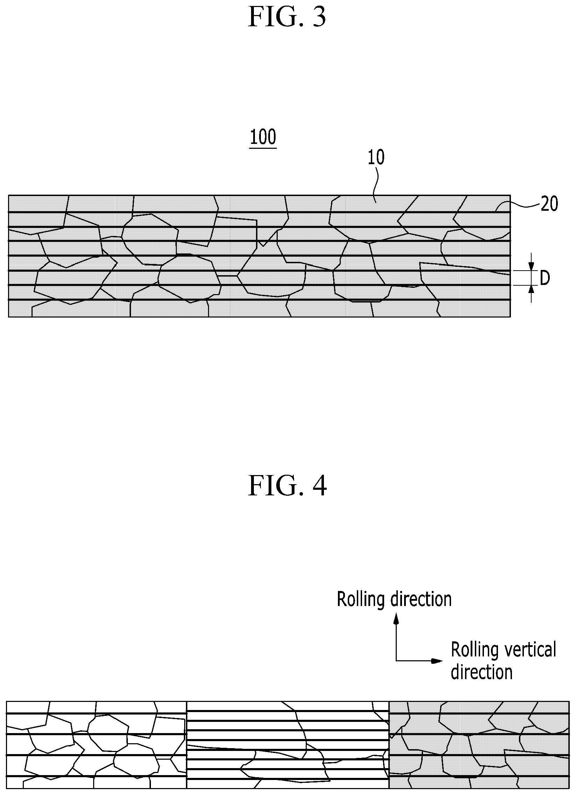

In addition, as illustrated in FIGS. 1 and 3, in an exemplary embodiment of the present invention, assuming that the particle size of grain is the same, as in FIG. 1, when the magnetic density is relatively small, the interval $D_G$ between the deformed parts is formed relatively large. In addition, when the magnetic density is relatively large as illustrated in FIG. 3 within the same sheet, the interval $D_G$ between the deformed parts is formed relatively small. In FIG. 3, the magnetic flux density is indicated in a dark color to mean that it is relatively high.

When the deformed part 20 exists, the magnetic flux density may inevitably deteriorate. In addition, when there are many deformed parts, that is, when the interval $D_G$ between the deformed parts is small, the magnetic flux density deteriorates in proportion thereto.

In an exemplary embodiment of the present invention, by adjusting the interval between the deformed parts according to the magnetic flux density, the amount of magnetic flux density deteriorated by the deformed part is reduced in an area where the magnetic flux density is relatively low, and the amount of magnetic flux density deteriorated by the deformed part relatively increases in an area where the magnetic flux density is relatively high, thereby further improving the magnetic flux density over the entire length of the sheet.

In an exemplary embodiment of the present invention, the particle size of grain is the particle size based on the rolling surface (ND surface). In addition, the particle size of grain means a particle diameter of a virtual circle having the same area as the grain.

It may be ideal to make the interval $D_G$ of the deformed part completely different for each grain or minimum area, but it is difficult to implement this within a rapidly moving sheet facility.

In an exemplary embodiment of the present invention, the section is divided in the transverse direction (TD direction) of the sheet, and the interval $D_G$ between the deformed parts 20 different for each section may be formed according to a particle size of grain 10 and a magnetic density included in each section. Specifically, the average particle size of the grain 10 and the magnetic flux density included in each section are obtained, and the interval $D_G$ between the deformed parts may be formed according to the index Ks of sensitivity. Specifically, it may be divided into 2 to 9 sections for the entire width of the sheet.

FIG. 4 is a schematic diagram in which the intervals between the deformed parts are formed differently by dividing the section in the rolling vertical direction (TD direction) of the sheet.

In an exemplary embodiment of the present invention, the section is divided in the rolling direction (RD direction) of the sheet, and the interval $D_G$ between the deformed parts 20 different for each section may be formed according to the particle size of the grain 10 and the magnetic density included in each section. Specifically, the average particle size of the grain 10 and the magnetic flux density included in each section are obtained, and the interval $D_G$ between the deformed parts may be formed according to the index Ks of sensitivity. Specifically, the section may be divided into 1 to 50 cm length intervals in the rolling direction (RD direction) of the sheet.

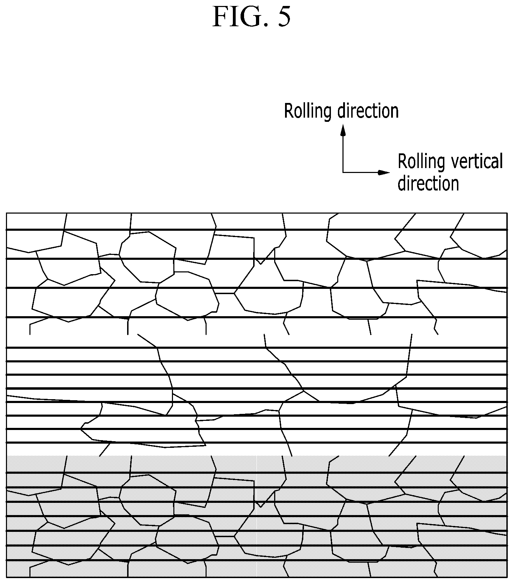

FIG. 5 is a schematic diagram in which the intervals between the deformed parts are formed differently by dividing the section in the rolling direction (RD direction) of the sheet. In FIGS. 4 and 5, the particle size of grain is expressed as rapidly changing for each section for explanation, but in the actual sheet, the particle size of grain and the magnetic flux density may change with a gradient before and after the section boundary. It is also possible to make the intervals between the deformed parts different by dividing the sections in the rolling vertical direction (TD direction) and rolling direction (RD direction) of the sheet, that is, in a grid form.

As described above, in an exemplary embodiment of the present invention, the interval $D_G$ between the deformed parts changes in response to the index Ks of sensitivity reflecting both the particle size of grain and the magnetic flux density. When the interval $D_G$ between the deformed parts is determined by the particle size of grain or the magnetic flux density alone, the deviation in the magnetic flux density over the entire length of the sheet or the deviation in the core loss becomes severe, so the magnetism over the entire length of the sheet may deteriorate. More specifically, when the index Ks of sensitivity is large in each area of the entire length of the sheet, the interval $D_G$ between the deformed parts is relatively narrow, and when the index Ks of sensitivity is small, the interval $D_G$ between the deformed parts may change relatively wide.

More specifically, the index Ks of sensitivity and the interval ($D_G$, mm) between the deformed parts may satisfy Equation 2 below.

$$[\text{Equation 2}]$$

$$(0.25 \times Ks) + 1.2 \leq D_G \leq (0.35 \times Ks) + 4.2$$

When Equation 2 is not satisfied, the core loss and magnetic flux density characteristics significantly deteriorate. As in the related art, when the interval $D_G$ between the deformed parts is uniformly given regardless of the particle size of grain and the magnetic flux density, the above Equation 2 may not be satisfied depending on the deviation in the particle size of grain and the magnetic flux density, and the core loss and magnetic flux density characteristics may deteriorate.

More specifically, the index Ks of sensitivity and the interval ($D_G$, mm) between the deformed parts may satisfy Equation 2-1 below.

$$[\text{Equation 2-1}]$$

$$(0.23 \times Ks) + 1.4 \leq D_G \leq (0.3 \times Ks) + 3.5$$

More specifically, the index Ks of sensitivity and the interval ($D_G$, mm) between the deformed parts may satisfy Equation 2-2 below.

$$[\text{Equation 2-2}]$$

$$(0.25 \times Ks) + 1.2 \leq D_G \leq (0.35 \times Ks) + 4.2$$

More specifically, the index Ks of sensitivity and the interval ($D_G$, mm) between the deformed parts may satisfy Equation 2-3 below.

[Equation 2-3]

$$(0.3 \times K_s) + 1.9 \leq D_G \leq (0.3 \times K_s) + 2.3$$

The deformed part may include a temporary magnetic domain deformed part, a permanent magnetic domain deformed part, or a combination thereof. The temporary magnetic domain deformed part is a deformed part in which the magnetic domain is refined by applying thermal shock to the surface of the sheet. The temporary magnetic domain deformed part may not be visually distinguished from surfaces of other sheets. The temporary magnetic domain deformed part is a part that is etched in the form of a groove when immersed in hydrochloric acid for 10 minutes at a concentration of 5%, and may be distinguished from surface parts of other sheets that are not etched. The permanent magnetic domain deformed part is a deformed part in which the magnetic domain is refined by forming grooves on the surface of the sheet. A depth of the permanent magnetic domain deformed part may be 10 to 30 $\mu$m.

As illustrated in FIGS. 1 to 3, the deformed part may be formed on one or both sides of the electrical sheet in a direction crossing the rolling direction (RD direction). As illustrated in FIGS. 1 to 3, as the deformed part may be formed in a linear form. Alternatively, although not illustrated, the deformed part may be formed in the form of dots arranged in a direction crossing the rolling direction (RD direction).

The linear deformed part 20 or the dotted deformed part is formed in plurality along the rolling direction, the linear deformed part 20 or the dotted deformed part may be formed continuously or discontinuously, and the linear deformed part 20 or the dotted deformed part may be formed by dividing into at least two pieces in the rolling vertical direction (TD direction) of the sheet. Hereinafter, the linear deformed part 20 will be mainly described.

As illustrated in FIGS. 1 to 3, in the electrical sheet in which the linear deformed part 20 is formed in a direction crossing the rolling direction (RD direction), a Forsterite layer is formed on the surface of the sheet by a final high-temperature annealing process to be described later, and an insulating coating layer 40 is continuously formed on the surface of the sheet on which the Forsterite layer is formed and on the linear deformed part 20.

The electrical sheet 100 has secondary recrystallization formed inside the sheet, and the particle size of the secondary recrystallization and the magnetic flux density formed on the electrical sheet 100 preferably have an index of sensitivity on core loss ($K_s$) value of 0.9 to 3.2, which is determined according to the following Equation 1.

$$0.9 \leq (0.7\, D_s + 0.3\, B)/10 \leq 3.2 \text{ -------------- } 1$$

(Where $D_s$: particle size of secondary recrystallization, B: magnetic flux density of sheet where secondary recrystallization is completed)

The index of sensitivity on core loss is an index obtained by calculating the size (unit: mm) of the secondary recrystallized grain and magnetic flux density (magnetic flux density T measured at magnetic field strength of 800 A/m) value of the electrical sheet and removing the unit.

The reason for introducing the index $K_s$ of sensitivity on core less in an exemplary embodiment of the present invention is as follows.

The technology of refining magnetic domains that forms deformed parts on the surface of the electrical sheet forms linear grooves on the surface of the sheet to obtain the magnetostatic effect by the free surface. However, the magnetostatic effect is determined by the orientation of Goss texture and the size of secondary recrystallized grain when the groove depth is the same, and the orientation of the Goss texture and the size of the secondary recrystallized grain change depending on the manufacturing process conditions of the electrical sheet.

That is, the grain oriented electrical sheet is subjected to hot rolling, hot rolled sheet annealing, cold rolling, decarburization (or primary recrystallization annealing), and final high temperature annealing (or secondary recrystallization annealing) to form the secondary recrystallization. The secondary recrystallization formed in this way is greatly influenced by other preceding process conditions, but is determined by the driving force for growth of the primary grain in the temperature rising process of the final high-temperature annealing process and the suppression force by grain boundary precipitates and intragrain precipitates and segregated elements. Furthermore, since the final high-temperature annealing process is a process in which the electric sheet is wound in a coil and treated in a batch furnace for a long time, the temperature at which the secondary recrystallization starts as the precipitate decomposition starts during the final high-temperature annealing process has different temperature histories depending on the temperature profile inside the batch furnace, the size and distribution of precipitates, and the locations of the inside, middle, and outside of the coil, etc., so the sizes of the secondary recrystallized grains in the width/longitudinal direction of the coil are inevitably different.

Therefore, in order to maximize the magnetostatic effect by forming the deformed part 20 on the electrical sheet, it is necessary to check the orientation of the Goss texture and the particle size of the secondary recrystallized grain, and control the magnetic domain refinement conditions accordingly.

In the present invention, the orientation of the Goss texture is indirectly checked through the degree of integration of the Goss texture by measuring the magnetic flux density of the electrical sheet, and the size of the secondary recrystallized grain is a Hall sensor (Hall-Sensor) method that measures the stray field at the grain boundary.

Next, the reason for limiting the value of the index Ks of sensitivity on core loss to 0.9 to 3.2 will be explained.

When the value of the index of sensitivity on core loss according to an embodiment of the present invention is high, the maximum core loss improvement rate may be obtained when the interval $D_G$ of the deformed part is relatively wide. However, when the value of the index of sensitivity on core loss is too low, the secondary grain is too small, and as described below, the core loss improvement effect may not be obtained at the interval $D_G$ between the deformed part of 2.0 to 4.5 mm, and when the value of the index of sensitivity on core loss is too large, the size of the secondary grain is too large, and the core loss improvement effect is insignificant even under the condition that the interval $D_G$ between the deformed parts is good. More specifically, the value of the index Ks of sensitivity on core loss may be 1.2 to 2.0.

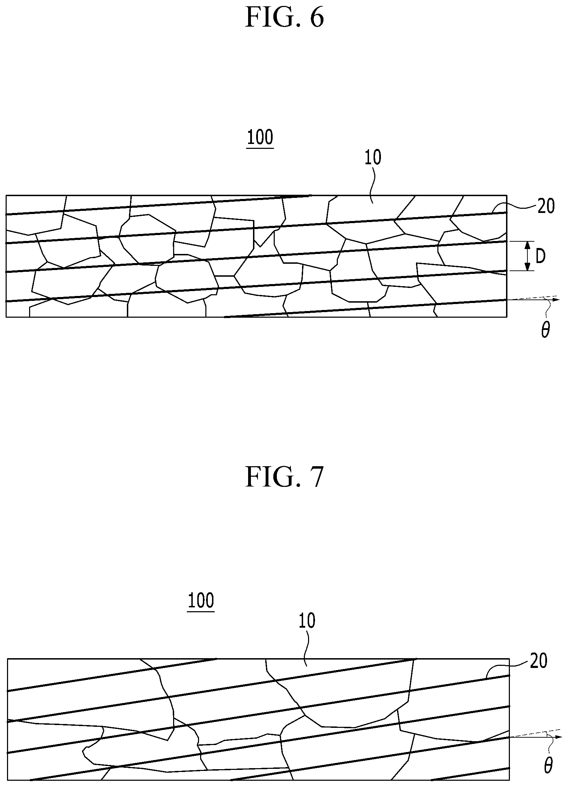

FIGS. 6 to 8 illustrate schematic diagrams of a grain oriented electrical sheet 100 subjected to magnetic domain refinement treatment according to another embodiment of the present invention.

Another embodiment of the present invention provides a grain oriented electrical sheet including: a plurality of deformed parts formed on a surface of the electrical sheet along a rolling direction, in which angles of the deformed part and a rolling vertical direction may be changed over an entire length of the sheet in response to an index Ks of sensitivity calculated by Equation 1 below, and there may be at least two areas having different angles of the deformed part and the rolling vertical direction.

[Equation 1]

$$Ks= (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

The angle θ of the deformed part and the rolling vertical direction means the angle between the longitudinal direction of the deformed part and the rolling vertical direction (TD direction) of the sheet in the case of the linear deformed part on the rolling surface (ND surface) of the sheet, and means the angle θ between the arrangement direction of the deformed part and the rolling vertical direction (TD direction) of the sheet in the case of the dotted deformed part. In one exemplary embodiment of the present invention, the negative/positive angle is displayed without distinction.

As illustrated in FIGS. 6 and 7, in an exemplary embodiment of the present invention, assuming that the magnetic flux density is the same, as in FIG. 6, when the particle size of grain is relatively small, the angle θ of the deformed part and the rolling vertical direction is formed relatively small. In addition, when the particle size of grain is relatively large as illustrated in FIG. 7 within the same sheet, the angle θ of the deformed part and the rolling vertical direction is relatively large.

When the particle size of grain is different, the internal structure called magnetic domain is different because the magnetic properties inside the grain are different. In other words, when the particle size of grain is large, clusters with similar magnetic domains are located large, and when the particle size of grain is small, clusters with similar magnetic domains are located small.

On the other hand, when the particle size of grain is relatively small, there is no problem even if the magnetic domain refinement is performed with the relatively small angle θ of the deformed part and the rolling vertical direction, but when the particle size of grain is relatively large, the angle θ of the deformed part and the rolling vertical direction are necessary to increase. Despite the small particle size of grain, when the magnetic domain is refined so that the angle θ of the deformed part and the vertical direction of rolling are large, the problem of reducing the improvement rate of the core loss of the magnetic material may occur due to the reduction of the demagnetizing effect. Therefore, the core loss may be further improved by changing the angle θ of the deformed part and the rolling vertical direction corresponding to each particle size of grain.

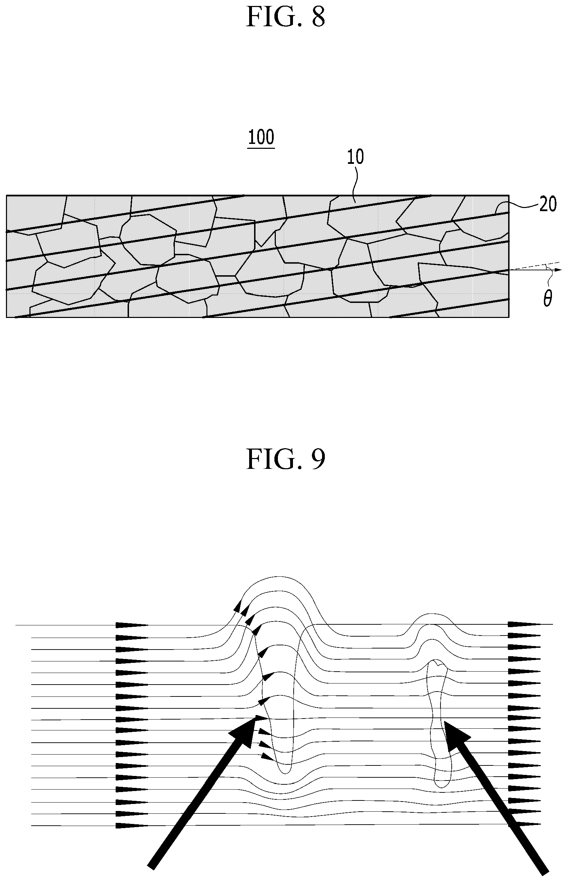

In addition, as illustrated in FIGS. 6 and 8, in an exemplary embodiment of the present invention, assuming that the particle size of grain is the same, as in FIG. 6, when the magnetic flux density is relatively small, the angle θ of the deformed part and the rolling vertical direction is formed relatively small. In addition, when the magnetic density is relatively large as illustrated in FIG. 8 within the same sheet, the angle θ of the deformed part and the rolling vertical direction is relatively large. In FIG. 8, the magnetic flux density is indicated in a dark color to mean that it is relatively high.

When the deformed part 20 exists, the magnetic flux density may inevitably deteriorate. In addition, when the angle θ of the deformed part and the vertical direction of rolling is large, the core loss improvement effect compared to the magnetic flux density is rapidly reduced.

In an exemplary embodiment of the present invention, by adjusting the angle θ between the deformed part and the rolling vertical direction according to the magnetic flux density, the amount of magnetic flux density deteriorated by the deformed part is reduced in an area where the magnetic flux density is relatively low, and the amount of magnetic flux density deteriorated by the deformed part relatively increases in an area where the magnetic flux density is relatively high, thereby further improving the magnetic flux density over the entire length of the sheet.

It may be most ideal to make all the angles θ of the deformed part and the rolling vertical direction different for each grain or minimum area, but it is practically difficult to implement this in a fast-moving steel plate facility.

In an exemplary embodiment of the present invention, the section is divided in the rolling vertical direction (TD direction) of the sheet, and the angle θ of the deformed parts 20 and the rolling vertical direction different for each section may be formed according to the particle size of grain 10 and the magnetic density included in each section. Specifically, the average particle size of the grain 10 and the magnetic flux density included in each section are obtained, and the angle θ of the deformed part and the rolling vertical direction may be formed according to the index Ks of sensitivity. Specifically, it may be divided into 2 to 9 sections for the entire width of the sheet.

In FIG. 4, since an example of dividing a section in the vertical direction (TD direction) of the sheet rolling has been described, duplicate descriptions will be omitted.

Alternatively, in an exemplary embodiment of the present invention, the section is divided in the rolling direction (TD direction) of the sheet, and the angle θ of the deformed part 20 and the rolling vertical direction different for each section may be formed according to the particle size of grain 10 and the magnetic density included in each section. Specifically, the average particle size of the grain 10 and the magnetic flux density included in each section are obtained, and the angle θ of the deformed part and the rolling vertical direction may be formed according to the index Ks of sensitivity. Specifically, the section may be divided into 1 to 50 cm length intervals in the rolling direction (RD direction) of the sheet.

In FIG. 5, since an example of dividing a section in the rolling direction (RD direction) of the sheet rolling has been described, duplicate descriptions will be omitted. It is also possible to make the intervals between the deformed parts different by dividing the sections in the rolling vertical direction (TD direction) and rolling direction (RD direction) of the sheet, that is, in a grid form.

As described above, in an exemplary embodiment of the present invention, the angle θ of the deformed part and the rolling vertical direction changes in response to the index Ks of sensitivity reflecting both the particle size of grain and the magnetic flux density. When the angle θ of the deformed part and the rolling vertical direction is determined by the particle size of grain or the magnetic flux density alone, the deviation in the magnetic flux density over the entire length of the sheet or the deviation in the core loss becomes severe, so the magnetism over the entire length of the sheet may deteriorate. More specifically, when the index Ks of sensitivity is large in each area of the entire length of the sheet, the angle θ of the deformed part and the rolling vertical direction are relatively large, and when the index Ks of sensitivity is small, the angle θ of the deformed part and the rolling vertical direction may change relatively small.

More specifically, the index Ks of sensitivity and the angles ($A_G$, °) of the deformed part and the rolling vertical direction may satisfy Equation 3 below.

[Equation 3]

$$(-0.45 \times Ks) + 0.8 \leq |A_G| \leq (-0.25 \times Ks) + 6.5$$

Since descriptions of other deformed parts are common to those described above, overlapping descriptions will be omitted.

More specifically, the index Ks of sensitivity and the angle ($A_G$, °) of the deformed part and the rolling vertical direction may satisfy Equation 3-1 below.

[Equation 3-1]

$$(-0.4 \times Ks) + 0.8 \leq |A_G| \leq (-0.3 \times Ks) + 6.5$$

More specifically, the index Ks of sensitivity and the angle ($A_G$, °) of the deformed part and the rolling vertical direction may satisfy Equation 3-2 below.

[Equation 3-2]

$$(-0.35 \times Ks) + 3 \leq |A_G| \leq (-0.35 \times Ks) + 4.5$$

In Equations 3 to 3-2, $|A_G|$ means the absolute value of $A_G$, and when the left side or right side is calculated as less than 0, it is interpreted as 0.

Another embodiment of the present invention provides a method for refining magnetic domains in a grain oriented electrical sheet including: measuring a particle size of grain and magnetic flux density of the sheet; calculating an index Ks of sensitivity of Equation 1 below based on the measured particle size of grain and magnetic flux density value; and forming a deformed part by determining an interval between the deformed parts in response to the index Ks of sensitivity, in which the deformed part may be formed so that there are at least two areas in which an interval between the deformed parts is different. In this case, the deformed part may be formed so that there are at least two areas in which an interval between the deformed parts is different

First, the particle size of grain and the magnetic flux density of the sheet is measured. In an exemplary embodiment of the present invention, as a method for measuring the particle size of grain, any method capable of measuring the particle size of grain in real time and reflecting the measured particle size of grain when forming the deformed part to be described later can be used without limitation.

As an example of the method for measuring the particle size of grain of a sheet, a magnetic flux leakage method may be used. Specifically, the step of measuring the particle size of grain may include magnetizing the sheet by applying magnetic force to the surface of the sheet, detecting the stray field formed by the grain boundary, and measuring the grain size by calculating the detected stray field.

Grain has a difference in magnetic property between the inside of the grain and the grain boundary. Due to this, when the magnetic sensor is located at the corresponding position, a large change occurs in the magnitude of the measurement signal due to the change in the magnetic field at the grain boundary.

FIG. 9 illustrates the change in the magnetic field. It is the part where the magnitude of the measurement signal changes in the part indicated by the arrow, and it may be measured that the grain boundary exists.

Using this, the particle size of grain may be measured by measuring the grain boundary. In addition, when the sensors are placed side by side in the direction perpendicular to the scanning direction, grains may be displayed as high-resolution two-dimensional images according to the sensor interval, so the particle size of grain may be clearly distinguished.

In other words, the sheet is magnetized in a certain direction with a magnetizer (electromagnet or permanent magnet), and the defect is detected by measuring the magnetic field leaked to the outside due to the defect existing in the sheet with the magnetic sensor such as Hall Sensor or GMR. The magnetic field generated by the magnetizer magnetizes the ferromagnetic sheet in a specific direction, and the magnetic field flows uniformly in the inner region of grain, but in the grain system, leakage magnetic flux occurs, and the vertical component of the leaked magnetic flux is measured by the magnetic sensor of Hall sensor, or the like.

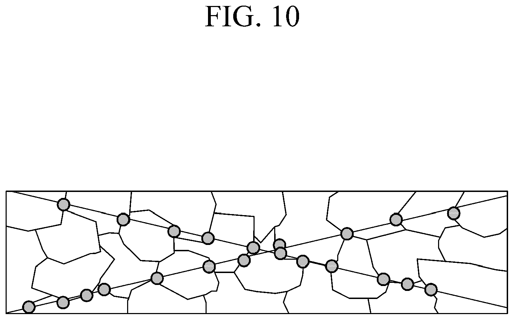

There are various methods such as area measurement method and overlapping area measurement method to obtain the particle size of grain from the measured grain boundary, and it is not particularly limited. For example, in the area measurement method, the particle size of grain may be obtained by drawing an arbitrary line in a certain area, measuring the number of areas that encounter the grain boundary, and then converting the measured area by dividing the measured area by the total area. FIG. 10 illustrates simulating the same. In FIG. 10, after drawing two lines diagonally for a certain area, the number of areas (circled areas) that collide with the grain boundary is measured and converted.

The magnetic flux density is a value obtained by integrating the voltage induced in the secondary coil by the magnetic field applied to the primary coil and unit area for a unit time, and may be measured for a unit length in the transverse direction of the sheet.

The particle size of grain and the magnetic flux density may be measured simultaneously or sequentially. As described above, it is possible to form the interval between different deformed parts for each section according to the average particle size of grain and average magnetic flux density measured for each section by dividing the section in the rolling vertical direction, in the rolling direction, or in the rolling vertical direction and rolling direction of the sheet.

Next, the index Ks of sensitivity is calculated based on the measured particle size of grain and magnetic flux density value. Since the index of sensitivity has been described above, a detailed description thereof will be omitted.

Next, the deformed part is formed by determining the interval between the deformed parts in response to the index Ks of sensitivity.

The index Ks of sensitivity and the interval ($D_G$, mm) between the deformed parts may satisfy Equation 2 below.

## [Equation 2]

$$(0.20 \times Ks) + 1.0 \leq D_G \leq (0.36 \times Ks) + 4.3$$

As a method for forming the deformed part, various methods may be used without limitation. Specifically, the method may include irradiating at least one of laser, electron beam, or plasma to the sheet; etching using an acid; colliding particles.

For example, the laser used to form the permanent deformed part 20 on the sheet may use a discontinuous or continuous laser beam having an average output of 300 W and a beam quality of M2≤1.80. By irradiating the surface of the electrical sheet with a beam using a laser in this range, a heat source higher than the melting heat of the sheet is absorbed by the sheet, and as a result, melting, vaporization, and explosion phenomena occur simultaneously, and grooves are formed.

When irradiating a continuous wave laser, a degree of scattering of a spatter that appears as a melt explosion during the melt-explosion process is somewhat different depending on the type of inert gas used during laser irradiation, but it is difficult to completely suppress the difference in the spatter scattering, and when irradiating a non-continuous wave laser, the spatter scattering may be minimized to some extent by supplying heat higher than the heat of vaporization to a sheet, but some fine dust may be generated during vaporization, and a low scanning speed may appear compared to the continuous wave laser irradiation.

Therefore, in order to minimize the formation of defects such as spatters or hill-ups formed near the grooves on the surface of the electrical sheet, a pulsed laser may be used. As such a pulse laser, a nanosecond, picosecond, or femtosecond laser having an output of 30 W or more is used, and the scanning speed may be set to be a maximum of 50 m/s or less. The interval between the deformed parts 20 may be 2.0 to 4.5 mm, and the width of the deformed part 20 in the rolling direction may be 10 to 40 $\mu$m.

Another embodiment of the present invention provides a method for refining magnetic domains in a grain oriented electrical sheet includes: measuring a particle size of grain and magnetic flux density of the sheet; calculating an index Ks of sensitivity of Equation 1 below based on the measured particle size of grain and magnetic flux density value; and forming a deformed part by determining angles of the deformed part and a rolling vertical direction in response to the index Ks of sensitivity, in which the deformed part may be formed so that there are at least two areas in which the angles of the deformed part and the rolling vertical direction are different.

## [Equation 1]

$$Ks = (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

Since the step of measuring the particle size of grain and magnetic flux density, the step of calculating the index Ks of sensitivity, and the step of forming the deformed part are the same as those described above, duplicate descriptions will be omitted. Since the method for determining the angle of the deformed part and the rolling vertical direction has also been specifically described in relation to the grain oriented electrical sheet described above, duplicate descriptions will be omitted.

The index Ks of sensitivity and the angles ($A_G$, °) of the deformed part and the vertical direction of rolling may satisfy Equation 3 below.

## [Equation 3]

$$(-0.45 \times Ks) + 0.8 \leq |A_G| \leq (-0.25 \times Ks) + 6.5$$

The deformed part may include a temporary magnetic domain deformed part, a permanent magnetic domain deformed part, or a combination thereof. The temporary magnetic domain deformed part is a deformed part in which the magnetic domain is refined by applying thermal shock to the surface of the sheet. Hereinafter, for convenience of description, the deformed part is unified and expressed as a linear groove.

Laser domain refinement according to an exemplary embodiment of the present invention irradiates a laser to a sheet having a value of an index of sensitivity on core loss of 0.9 to 3.2 in a direction crossing the rolling direction to form a linear deformed part 20 having a depth of 10 to 35 $\mu$m, in which the laser beam is preferably irradiated at an irradiation interval in the range of 2.0 to 4.5 mm and an irradiation angle in the range of 0 to 5°. The width of the linear deformed part formed by the laser beam may be 10 to 40 μm.

As the laser used to form the linear grooves 20 on the electrical sheet, it is preferable to use a discontinuous or continuous laser beam having an average output of 300 W and a beam quality of M2≤1.80. By irradiating the surface of the electrical sheet with a beam using a laser in this range, a heat source higher than the melting heat of the sheet is absorbed by the sheet, and as a result, melting, vaporization, and explosion phenomena occur simultaneously, and grooves are formed.

When irradiating a continuous wave laser, the degree of scattering of the spatter that appears as the melt explosion during the melt-explosion process is somewhat different depending on the type of inert gas used during laser irradiation, but it is difficult to completely suppress the difference in the spatter scattering, and when irradiating a non-continuous wave laser, the spatter scattering may be minimized to some extent by supplying heat higher than the heat of vaporization to a sheet, but some fine dust may be generated during vaporization, and a low scanning speed may appear compared to the continuous wave laser irradiation.

Therefore, in order to minimize the formation of defects such as spatters or hill-ups formed in the groove parts of the electrical sheet, the pulsed laser may be used. As such a pulse laser, a nanosecond, picosecond, or femtosecond laser having an output of 30 W or more is used, and the scanning speed may be preferably set to be a maximum of 50 m/s or less.

In the grain oriented electrical sheet, the cold-rolled sheet is prepared by heating a slab made of 2.0 to 6.5 wt% of Si, other unavoidable impurities, and the balance Fe and then performing hot rolling and cold rolling on the slab.

Here, the grain oriented electrical sheet includes, by wt%, 0.10% or less of C (excluding 0%), 0.005 to 1.0% of Mn, 0.05% or less of Nb+V+Ti (excluding 0%), 0.8% or less of Cr+Sn (excluding 0%), 3.0% or less of Al (excluding 0%), 0.09% or less of P+S (excluding 0%), and 0.5% or less (excluding 0%) of a total amount of rare earth elements and other impurities while satisfying the equation Sn% + Sb% - 0.7 Cr % ≤ 0.07. The present invention relates to the magnetic domain refinement of the grain oriented electrical sheet, and has a magnetic improvement effect due to the formation of the deformed part regardless of the steel component of the grain oriented electrical sheet, but is not limited to the above-mentioned steel component. Hereinafter, the reasons for limiting the composition of the grain oriented electrical sheet will be supplementarily described.

[C: 0.10% or less (excluding 0%)]

Carbon (C) is an element that is inevitably incorporated into steel, but deteriorates magnetic properties due to magnetic aging, so it is preferable to control the content to an appropriate level. When the C content is too small in the sheet, phase transformation does not occur sufficiently during the manufacturing process, resulting in non-uniformity of the microstructure of the sheet and unstable secondary recrystallization patterns, and when the C content is included in the sheet too small, during the manufacturing process, carbides become coarse and the amount of precipitation is excessive. As a result, decarburization is not sufficiently performed, and the integration of the Goss texture deteriorates, which may damage the secondary recrystallized texture. Therefore, the C content of the sheet is 0.10% or less, and more preferably 0.001 to 0.040%.

[Si: 2.0 to 6.5 %]

Silicon (Si), as a basic composition of the grain oriented electrical sheet, serves to lower core loss by increasing the specific resistance of the sheet. When the Si content is too small, the specific resistance decreases, an eddy current loss increases, and the core loss characteristics deteriorate, so the effect of adding Si may not be expected. when the Si content is included too much, the brittleness of the sheet increases and the toughness decreases, which may cause sheet breakage during the rolling process, and since nitride is not sufficiently formed during the manufacturing process, it is not possible to secure sufficient crystal grain suppression power necessary for the formation of secondary recrystallization in the final high-temperature annealing process. Therefore, Si is preferably 2.0 to 6.5%.

[Mn: 0.005 to 1.0%]

Manganese (Mn) has the effect of reducing total core loss by increasing the specific resistance to reduce the eddy current loss, and reacts with S in a lull state to form Mn-based sulfides, as well as reacts with nitrogen introduced by nitriding along with Si to form precipitates of (Al,Si,Mn)N, so it is an important element that not only causes secondary recrystallization by inhibiting the growth of the primary recrystallized grains, but affects the surface quality of final products. However, when Mn is included too small, the surface quality of the final product may deteriorate. In addition, when Mn is included too much, the austenite phase fraction is greatly increased, the Goss texture is damaged, the magnetic flux density is reduced, and an oxide layer is excessively formed during decarburization annealing, which may hinder the decarburization. Therefore, Mn is preferably 0.005 to 1.0%.

[Nb+V+Ti: 0.05% or less (excluding 0%)]

Niobium (Nb), vanadium (V), and titanium (Ti) are elements that form precipitates by reacting with C and N during the manufacturing process, but when the niobium (Nb), vanadium (V), and titanium (Ti) are added too much, since the niobium (Nb), vanadium (V), and titanium (Ti) remain in the sheet even after the secondary recrystallization annealing and deteriorates the magnetic properties of the sheet, it is preferable to control the total amount of at least one element selected from Nb, V, and Ti to 0.05% or less.

[Cr+Sn: 0.8% or less (excluding 0%)]

Chromium (Cr) is added for the purpose of reducing core loss by promoting the formation of the Goss texture, and Sn is added for the purpose of ultimately improving the magnetic flux density by suppressing the grain growth. Therefore, within this target range, it is preferable to add 0.8% or less of these elements in total.

[Al: 3.0% or less (excluding 0%)]

In addition to Al-based nitrides precipitated during the manufacturing process, aluminum (Al) is coupled with N introduced by nitriding treatment during the primary recrystallization process and Al, Si, and Mn present in a solid solution in steel to form (Al, Si, Mn)N and AlN-type nitride, and thus, serves as a strong grain growth inhibitor. However, when Al is included too much, it is preferable to add less than 3.0% because precipitates are non-uniform and the formation of secondary recrystallization is unstable and the magnetic properties of the sheet are lowered.

[P+S: 0.09% or less (excluding 0%)]

Phosphorus (P) segregates in the grain system to hinder the movement of the grain system and at the same time plays an auxiliary role in suppressing grain growth. When S is added too much, the formation of the secondary recrystallization becomes unstable. In addition, P and S are elements that are inevitably added during the manufacturing process of the electrical sheet, and it is preferable to control the total of P and S to 0.09% or less.

[Sn % + Sb % - 0.7Cr % $\leq$ 0.07]

Tin (Sn) and chromium (Cr) are as described above, and antimony (Sb) has an effect of stabilizing secondary recrystallization by segregating in the grain system to inhibit the grain growth. Since all of these three elements have a mutual relationship with the formation of the secondary recrystallized structure, it is preferable to control the total of Sn, Sb, and $0.7 \times$Cr to 0.07 or less.

[Total of rare earth elements and other impurities is 0.5% or less]

The grain oriented electrical sheet according to the exemplary embodiment of the present invention may include rare earth elements such as cerium (Ce) or praseodymium (Pr) and other impurities, and even if any rare earth elements and impurities are included, the total is preferably 0.5% or less. The rare earth elements and unavoidable impurities refer to impurities intentionally introduced or unavoidably mixed during steelmaking and the manufacturing process of the grain oriented electrical sheet. Since the unavoidable impurities are widely known, detailed descriptions are omitted. In an exemplary embodiment of the present invention, the addition of elements other than the above-described alloy components is not excluded, and may be variously included within a range that does not impair the technical spirit of the present invention. When additional elements are included, they are included in place of Fe, which is the balance.

Next, the sheet having a slab having the above composition is manufactured to have a thickness in the range of 0.1 to 0.5 mm by preparing the slab by continuous casting, followed by heating and hot rolling in a conventional manner, and selectively annealing the hot-rolled sheet as necessary, followed by cold rolling. Here, as the cold rolling, one cold rolling or two or more cold rolling with intermediate annealing interposed therebetween may be performed.

In addition, the cold-rolled sheet subjected to the cold rolling is subjected to primary recrystallization annealing through a simultaneous decarburization or post-decarburization nitrification process. In the case of the primary recrystallization annealing by the simultaneous decarburization, the structure of the cold rolling deformed during the annealing process is subjected to decarburization annealing including recrystallization. To this end, it is performed in a mixed gas atmosphere in which nitrogen, hydrogen, and moisture are mixed. In addition, in the case of nitriding after decarburization, nitriding treatment may be performed by introducing nitrogen ions into the sheet using ammonia gas after decarburization.

In the case of the simultaneous decarburization, the dew point temperature of the atmospheric gas is set to 40 to 70°C for the cold-rolled sheet loaded in the furnace in the range of 700 to 900°C, and the $Fe_2SiO_4/SiO_2$ ratio of the surface is controlled to 0.5 to 3.0 to form an oxide layer on the surface of the electrical sheet.

Then, an annealing separator based on MgO is applied to the surface of these electrical sheets, and then the temperature is raised to 1,000°C or higher and crack annealing is performed for a long time to cause the secondary recrystallization, so a {110} surface of the sheet is parallel to the rolling surface, a <001> direction forms a texture of a Goss orientation parallel to the rolling direction. By the final high-temperature annealing process, a Forsterite layer is formed on the surface of the sheet and the secondary recrystallization is formed inside the sheet.

In this way, for the secondary recrystallization formed inside the sheet by the final high temperature annealing step, since the secondary recrystallization has a difference in the recrystallization start temperature for each coil position, the size of the secondary recrystallization generated and magnetic flux density are measured for each coil position.

In this case, the value of the index Ks of sensitivity on core loss defined by Equation 1 for the size of the secondary recrystallization and the magnetic flux density measured may be in the range of 0.9 to 3.2.

A laser is irradiated on the surface of the electrical sheet to form the linear groove having a depth of 10 to 35 μm in the direction crossing the rolling direction. In this case, it is preferable to set the irradiation interval of the laser beam to 2.0 to 4.5 mm and to irradiate the irradiation angle of the laser beam in the range of 0 to 5°.

The method for refining magnetic domains uses the pulse laser described above to form the linear grooves on the surface of the sheet.

Then, the sheet with linear grooves is coated with a single or coupled insulating coating solution of colloidal silica and metal phosphate, and then annealed to form an insulating coating layer on the surface of the electrical sheet.

A method of forming such an insulating coating layer may be used without particular limitation, and for example, an insulating coating layer may be formed by applying an insulating coating liquid containing phosphate. As such an insulating coating liquid, it is preferable to use a coating liquid containing colloidal silica and a metal phosphate. In this case, the metal phosphate may be Al phosphate, Mg phosphate, or a combination thereof, and the content of Al, Mg, or a combination thereof relative to the weight of the insulating coating solution may be 15 wt% or more.

After performing the insulation coating, a stress relief annealing (SRA) step may be further included. The temperature during SRA may be 700 to 900°C.

Hereinafter, the present invention will be described in more detail through examples. However, these examples are only for illustrating the present invention, and the present invention is not limited thereto.

**Experimental Example 1**

A cold-rolled sheet having a thickness of 0.23 mm was manufactured by hot rolling and cold rolling on a slab having the composition shown in Table 1 below.

In Table 1, element % means weight %.

(Table 1)

| C (%) | Si (%) | Mn (%) | Nb (%) | V (%) | Ti (%) | Cr (%) | Sn (%) | Al (%) | P (%) | S (%) | Sb (%) | balance |
|---|---|---|---|---|---|---|---|---|---|---|---|---|
| 0.05 | 3.45 | 0.10 | 0.001 | 0.001 | 0.002 | 0.10 | 0.052 | 0.029 | 0.03 | 0.01 | 0.02 | Fe |

The cold-rolled sheet was maintained at a temperature of 840°C for 150 seconds in humid hydrogen, nitrogen and ammonia mixed gas atmosphere (the dew point temperature was 69°C, and the $Fe_2SiO_4/SiO_2$ ratio was controlled to 1.2), and was subjected to decarburization annealing and nitriding treatment including primary recrystallization annealing. The sheet was applied with MgO which is an annealing separator, and subjected to secondary recrystallization annealing, subjected to the secondary recrystallization annealing in a mixed atmosphere of 25 vol% nitrogen and 75 vol% hydrogen up to 1,150°C, and after reaching 1,150°C, was maintained in a 100 vol% hydrogen atmosphere for about 8 hours and then furnace cooled.

For a sheet that had completed secondary recrystallization annealing through the final high-temperature annealing process, the size of the secondary recrystallized grain and the magnetic flux density value, which may indirectly confirm the degree of integration of texture, were measured

Here, the size of the secondary recrystallized grain was measured using the Hall-Sensor method that measures the stray field at the grain boundary, and the magnetic flux density value (B8, Tesla) was measured with the magnetic flux density meter at a magnetic field strength of 800 A/m. In FIGS. 9 and 10, the photograph analyzed by the magnetic flux leakage method is illustrated.

The index of sensitivity on core loss was calculated using Equation 1 based on the measured size of the secondary recrystallized grain and the measured magnetic flux density of the sheet.

Then, while changing the calculated index of sensitivity on core loss value and also changing the irradiation interval of the laser beam from 2.0 to 4.5 mm, the linear grooves were formed on the surface of the sheet in a direction crossing the rolling direction.

As the laser used for the magnetic domain refinement, the pulse laser having an output of 300W was used, the scanning speed and scanning distance were 0.5m/s and 60 mm, respectively, and the irradiation angle was irradiated at 1° or less to form the linear grooves. In this case, the depth of the linear groove formed was 20 $\mu$m and the width of the linear groove was 15 $\mu$m.

A coating solution containing a mixture of colloidal silica nanoparticles and metal phosphate was applied to the surface of the linear grooved sheet, and heat treatment was performed at 870°C for 55 seconds to form the insulating coating layer for the grain oriented electrical sheet.

After forming the insulating coating layer, the stress relief annealing (SRA) treatment was performed at 840°C.

In this way, the core loss value of the sheet was measured before and after the SRA treatment for the sheet with the linear groove and the insulating coating layer formed, and summarized in Table 2 below, and the core loss improvement rate was calculated based on these measured values.

(Table 2)

| Index of sensitivity Ks | Irradiation interval (mm) | Core loss before treatment, (W/kg) | Core loss after magnetic domain refinement treatment (W/kg) | Core loss improvement rate (%) | Division |
|---|---|---|---|---|---|
| 0.9 | 2.0 | 0.82 | 0.75 | 8.5 | Example |
| | 2.2 | 0.82 | 0.72 | 12.2 | Example |
| | 2.4 | 0.82 | 0.75 | 8.5 | Example |
| | 4.5 | 0.82 | 0.79 | 3.7 | Example |
| | 6.0 | 0.82 | 0.82 | 0 | Comparative Example |
| 1.8 | 2.0 | 0.82 | 0.75 | 8.5 | Example |
| | 2.6 | 0.82 | 0.72 | 12.2 | Example |
| | 2.9 | 0.82 | 0.74 | 9.8 | Example |
| | 4.5 | 0.82 | 0.79 | 3.7 | Example |
| 3.2 | 0.2 | 0.82 | 0.84 | -2.3 | Comparative Example |
| | 2.0 | 0.82 | 0.76 | 7.3 | Example |
| | 2.9 | 0.82 | 0.72 | 12.2 | Example |
| | 4.5 | 0.82 | 0.79 | 3.7 | Example |
| 0.8 | 4.5 | 0.82 | 0.83 | -1.2 | Comparative Example |
| | 2.0 | 0.82 | 0.81 | 1.2 | Comparative Example |
| 3.3 | 4.5 | 0.82 | 0.84 | -2.4 | Comparative Example |
| | 2.0 | 0.82 | 0.85 | -3.6 | Comparative Example |

As can be seen in Table 2 above, in the sheet having the value of the index of sensitivity on core loss in the range of 0.9 to 3.2, the core loss is further improved when the value of the index of sensitivity is greater and the irradiation interval is relatively wide.

However, when the value of the index Ks of sensitivity was lower than 0.8, the size of the secondary grain was too small, so the core loss improvement effect could not be obtained even at the irradiation interval of 2.0 to 4.5 mm. In addition, even when the index Ks of sensitivity increases exceeding 2.7, the size of the secondary grain is too large, so the core loss improvement effect appears low under the irradiation interval condition, so it could be seen that the core loss is not improved.

In addition, even if the value of the index Ks of sensitivity value is in an appropriate range, if the interval between the deformed parts is too narrow or too wide not to satisfy Equation 2, it could be confirmed that the core loss improvement effect is not sufficient.

Next, in order to confirm the dependence of the irradiation angle of the laser according to the value of the index Ks of sensitivity on core loss, the electrical sheet was manufactured under the condition that the laser irradiation interval of Table 2 was set to 2.0 mm, and the irradiation angle changes from 0 to 5° while forming the linear groove by the laser, the rest of the experiments and measurements were the same as in Table 2, and then, the magnetic flux density of the sheet was measured with the magnetic flux density meter before and after the SRA treatment, which is summarized in Table 3 below. Based on the measured iron loss value, the iron loss improvement rate was calculated.

(Table 3)

| Index of sensitivity Ks | Irradiation angle | Core loss before treatment, (W/kg) | Core loss after magnetic domain refinement treatment (W/kg) | Core loss improvement rate (%) | Division |
|---|---|---|---|---|---|
| 0.9 | 0 | 0.82 | 0.85 | -3.7 | Comparative Example |
| | 0.5 | 0.82 | 0.75 | 8.5 | Example |
| | 3 | 0.82 | 0.72 | 12.2 | Example |
| | 5 | 0.82 | 0.76 | 7.3 | Example |
| 1.8 | 0 | 0.82 | 0.75 | 8.5 | Example |
| | 3 | 0.82 | 0.74 | 9.8 | Example |
| | 5 | 0.82 | 0.76 | 7.3 | Example |
| | 7 | 0.82 | 0.83 | 1.2 | Comparative Example |
| 0.8 | 0 | 0.82 | 0.81 | 1.2 | Comparative Example |
| | 3 | 0.82 | 0.8 | 2.4 | Comparative Example |
| | 5 | 0.82 | 0.82 | 0.0 | Comparative Example |

As shown in Table 3, it could be seen that the core loss improvement rate of 7.3% or more can be secured in the range of the value of the index Ks of sensitivity in the range of 0.9 and 1.8 within the range of the present invention and the irradiation angle in the range of 0 to 5°.

**Experimental Example 2**

A grain oriented electrical sheet was prepared in the same manner as in Experimental Example 1 described above, and specimens were prepared. The average particle size of grain and magnetic flux density were measured by dividing the specimen into a plurality of areas, and it was confirmed that the value of the index Ks of sensitivity for each area was variously distributed in the range of 0.9 to 1.8.

The interval between the deformed parts was adjusted to satisfy Equation 2-3 for each area, and the deformed part was formed in the same manner as in Experimental Example 1, which was used as an example. The angle of the deformed part was fixed at 3°.

In Comparative Examples 1 to 3, the interval between the deformed parts of 2.0 mm, 2.9 mm, and 4.5 mm were collectively applied, respectively, and Equation 2-3 was not satisfied in some areas. In Comparative Examples 4 and 5, the interval between the deformed part was adjusted by reflecting only the particle size of grain or the magnetic flux density, not the value of the index Ks of sensitivity, and Equation 2-3 was not satisfied in some areas.

The maximum core loss (W17/50) and minimum magnetic flux density B8 of Examples and Comparative Examples 1 to 5 were measured and are shown in Table 4 below

(Table 4)

|  | Deformed part interval | Core loss (W17/50, W/kg) | Magnetic flux density (B8, T) |
|---|---|---|---|
| Example | Variation application in range of 2mm to 4.5mm | 0.72 | 1.91 |
| Comparative Example 1 | Batch application with 2.0mm | 0.79 | 1.89 |
| Comparative Example 2 | Batch application with 2.9mm | 0.78 | 1.90 |
| Comparative Example 3 | Batch application with 4.5mm | 0.80 | 1.90 |
| Comparative Example 4 | Variation application in response to grain size | 0.76 | 1.90 |
| Comparative Example 5 | Variation application in response to magnetic flux density | 0.77 | 1.90 |

As shown in Table 4, it could be seen that the example in which the deformation part interval is appropriately controlled according to the index Ks of sensitivity significantly improves the magnetism compared to Comparative Examples 1 to 3. Comparative Example 4 and Comparative Example 5 also failed to satisfy Equation 2-3 in some areas, confirming that the magnetism improvement was not sufficient.

**Experimental Example 3**

A grain oriented electrical sheet was prepared in the same manner as in Experimental Example 1 described above, and specimens were prepared. The average particle size of grain and magnetic flux density were measured by dividing the specimen into a plurality of areas, and it was confirmed that the value of the index Ks of sensitivity for each area was variously distributed in the range of 0.9 to 1.8.

The angle of the deformed part and the rolling vertical direction was adjusted to satisfy Equation 3-2 for each area, and the deformed part was formed in the same manner as in Experimental Example 1, which was used as an example. The interval between the deformed part was fixed at 2.9 mm.

In Comparative Examples 5 to 8, the angle of the deformed part and the rolling vertical direction was collectively applied as 0°, 3°, and 5°, respectively, and Equation 3-2 was unsatisfactory in some areas. In Comparative Example 9 and Comparative Example 10, the interval between the deformed part was adjusted by reflecting only the particle size of grain or the magnetic flux density, not the value of the index Ks of sensitivity, and Equation 3-2 was not satisfied in some areas.

The maximum core loss (W17/50) and minimum magnetic flux density B8 of Examples and Comparative Examples 6 to 10 were measured and are shown in Table 5 below

(Table 5)

|  | Deformed part interval | Core loss (W17/50, W/kg) | Magnetic flux density (B8, T) |
|---|---|---|---|
| Example | Variation application in range of 0° to 5° | 0.71 | 1.91 |
| Comparative Example 6 | Batch application at 0° | 0.77 | 1.90 |
| Comparative Example 7 | Batch application at 3° | 0.77 | 1.89 |
| Comparative Example 8 | Batch application at 5° | 0.78 | 1.90 |
| Comparative Example 9 | Variation application in response to only grain size | 0.75 | 1.89 |

(continued)

|  | Deformed part interval | Core loss (W17/50, W/kg) | Magnetic flux density (B8, T) |
|---|---|---|---|
| Comparative Example 10 | Variation application in response to only magnetic flux density | 0.76 | 1.90 |

As shown in Table 5, it could be seen that the example in which the deformation part interval is appropriately controlled according to the index Ks of sensitivity significantly improves the magnetism compared to Comparative Examples 6 to 8. Comparative Example 9 and Comparative Example 10 also failed to satisfy Equation 3-2 in some areas, confirming that the magnetism improvement was not sufficient.

The present invention is not limited to the exemplary embodiments, but may be manufactured in a variety of different forms, and the present invention may be manufactured in a variety of different forms, and those of ordinary skill in the art to which the present invention pertains will understand that the present invention may be implemented in other specific forms without changing the technical spirit or essential features of the present invention. Therefore, it should be understood that the above-mentioned exemplary embodiments are exemplary in all aspects but are not limited thereto.

[Detailed Description of Main Elements]

   100: Grain oriented electrical sheet, 10: Grain
   20: Deformed part

Claims

1.   A grain oriented electrical sheet, comprising:

   a plurality of deformed parts formed on a surface of the electrical sheet along a rolling direction,
   wherein an interval between the deformed parts is changed over an entire length of the sheet in response to an index Ks of sensitivity calculated by Equation 1 below, and
   at least two areas having a different interval between the deformed parts exist.

[Equation 1]

$$Ks = (0.7 \times Ds + 0.3 \times B8)/10$$

   (in Equation 1, Ks denotes an index of sensitivity, Ds denotes a particle size of grain (mm), and B8 denotes a magnetic flux density T measured at magnetic field strength of 800 A/m.)

2.   The grain oriented electrical sheet of claim 1, wherein:
   the index Ks of sensitivity and the interval (Dc, mm) between the deformed parts satisfy Equation 2 below.

[Equation 2]

$$(0.20 \times Ks) + 1.0 \leq D_G \leq (0.36 \times Ks) + 4.3$$

3.   The grain oriented electrical sheet of claim 1, wherein:
   by dividing sections in a transverse direction of the sheet, the interval between the deformed parts that are different for each section is formed according to the index Ks of sensitivity for each section.

4.   The grain oriented electrical sheet of claim 1, wherein:
   by dividing sections in a rolling direction of the sheet, the interval between the deformed parts that are different for each section is formed according to the index Ks of sensitivity for each section.

5. An grain oriented electrical sheet, comprising:

a plurality of deformed parts formed on a surface of the electrical sheet along a rolling direction;
wherein angles of the deformed part and a rolling vertical direction are changed over an entire length of the sheet in response to an index Ks of sensitivity calculated by Equation 1 below, and
there are at least two areas having different angles of the deformed part and the rolling vertical direction.

[Equation 1]

$$Ks= (0.7 \times Ds + 0.3 \times B8)/10$$

(in Eqution 1, Ks denotes an index of sensitivity, Ds denotes a particle size of grain (mm), and B8 denotes a magnetic flux density T measured at magnetic field strength of 800 A/m.)

6. The grain oriented electrical sheet of claim 5, wherein:
the index Ks of sensitivity and the angles ($A_G$, °) of the deformed part and the vertical direction of rolling satisfy Equation 3 below.

[Equation 3]

$$(-0.45 \times Ks) + 0.8 \leq |A_G| \leq (-0.25 \times Ks) + 6.5$$

7. The grain oriented electrical sheet of claim 5, wherein:
by dividing sections in a transverse direction of the sheet, the angles of the deformed part and the rolling vertical direction that are different for each section are formed according to the index Ks of sensitivity for each section.

8. The grain oriented electrical sheet of claim 5, wherein:
by dividing sections in a rolling direction of the sheet, the angles of the deformed part and the rolling vertical direction that are different for each section are formed according to the index Ks of sensitivity for each section.

9. The grain oriented electrical sheet of claim 1 or claim 5, wherein:
the deformed part includes a temporary magnetic domain deformed part, a permanent magnetic domain deformed part, or a combination thereof.

10. The grain oriented electrical sheet of claim 9, wherein:
the deformed part includes the permanent magnetic domain deformed part, and a depth of the permanent magnetic domain deformed part is 10 to 30 $\mu$m.

11. A method for refining magnetic domains in a grain oriented electrical sheet, the method comprising:

measuring a particle size of grain and a magnetic flux density of the sheet;
calculating an index Ks of sensitivity of Equation 1 below based on the measured particle size of grain and magnetic flux density value; and
forming a deformed part by determining an interval between the deformed parts in response to the index Ks of sensitivity,
wherein the deformed part is formed so that there are at least two areas in which an interval between the deformed parts is different.

[Equation 1]

$$Ks=0.7 \times Ds + 0.3 \times B8$$

(in Equation 1, Ks denotes an index of sensitivity, Ds denotes a particle size of grain (mm), and B8 denotes a magnetic flux density T measured at magnetic field strength of 800 A/m.)

12. The method of claim 11, wherein:
the deformed part is formed so that the index Ks of sensitivity and the interval (Dc, mm) between the deformed parts satisfy Equation 2 below.

[Equation 2]

$$(0.20 \times Ks) + 1.0 \le D_G \le (0.36 \times Ks) + 4.3$$

13. A method for refining magnetic domains in a grain oriented electrical sheet, the method comprising:

measuring a particle size of grain and a magnetic flux density of the sheet;
calculating an index Ks of sensitivity of Equation 1 below based on the measured particle size of grain and magnetic flux density value; and
forming a deformed part by determining angles of the deformed part and a rolling vertical direction in response to the index Ks of sensitivity,
wherein the deformed part is formed so that there are at least two areas in which the angles of the deformed part and the rolling vertical direction are different.

[Equation 1]

$$Ks = (0.7 \times Ds + 0.3 \times B8)/10$$

(in Equation 1, Ks denotes an index of sensitivity, Ds denotes a particle size of grain (mm), and B8 denotes a magnetic flux density T measured at magnetic field strength of 800 A/m.)

14. The method of claim 13, wherein:
the index Ks of sensitivity and the angles ($A_G$, °) of the deformed part and the vertical direction of rolling satisfy Equation 3 below.

[Equation 3]

$$(-0.45 \times Ks) + 0.8 \le |A_G| \le (-0.25 \times Ks) + 6.5$$

15. The method of claim 11 or claim 13, wherein:

the measuring of the particle size of grain and the magnetic flux density of the sheet includes
applying magnetic force to the surface of the sheet to magnetize the sheet, detecting stray field formed by a grain boundary, and calculating the detected stray field to measure the particle size of grain.

16. The method of claim 11 or claim 13, wherein:

in the measuring of the particle size of grain and the magnetic flux density of the sheet,
the magnetic flux density is a value obtained by integrating a voltage induced in a secondary coil by a magnetic field applied to a primary coil and a unit area for unit time, and is measured for unit length in a transverse direction of the sheet.

17. The method of claim 11 or claim 13, wherein:
the forming of the deformed part includes irradiating the sheet with at least one of laser, electron beam, and plasma, etching using acid; or colliding particles.

18. The method of claim 17, wherein:

the forming of the deformed part includes irradiating the sheet with laser to form a permanent magnetic domain deformed part or a temporary magnetic domain deformed part.

FIG. 1

100

10

20

D

FIG. 2

100

10

20

D

# FIG. 3

100

10

20

D

# FIG. 4

Rolling direction

Rolling vertical direction

FIG. 5

Rolling direction

Rolling vertical
direction

# FIG. 6

# FIG. 7

# FIG. 8

# FIG. 9

FIG. 10

## FIG. 11

## FIG. 12

## INTERNATIONAL SEARCH REPORT

| International application No. |
| --- |
| **PCT/KR2022/020884** |

**A.    CLASSIFICATION OF SUBJECT MATTER**

**C21D 8/12**(2006.01)i; **C22C 38/34**(2006.01)i; **B23K 26/364**(2014.01)i; **H01F 1/147**(2006.01)i

According to International Patent Classification (IPC) or to both national classification and IPC

**B.    FIELDS SEARCHED**

Minimum documentation searched (classification system followed by classification symbols)

C21D 8/12(2006.01); C21D 10/00(2006.01); C22C 38/00(2006.01); H01F 1/16(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 방향성 전기강판(oriented electrical steel sheet), 자구(magnetic domain), 미세화 (refinement), 압연(rolling), 홈(groove), 간격(gap), 결정립(crystal grain), 자속밀도(magnetic flux density), 각도(angle), 입경 (particle size), 레이저(laser)

**C.    DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0076508 A (POSCO) 29 June 2020 (2020-06-29)<br>  See paragraphs [0040], [0041], [0048]-[0054], [0065], [0066], [0073]-[0077] and [0114] and figures 1, 3 and 4. | 1-18 |
| A | JP 11-087122 A (NIPPON STEEL CORP.) 30 March 1999 (1999-03-30)<br>  See paragraphs [0007]-[0010] and [0013]-[0019] and table 1. | 1-18 |
| A | KR 10-2021-0079129 A (POSCO) 29 June 2021 (2021-06-29)<br>  See claims 1-20. | 1-18 |
| A | WO 2016-171129 A1 (NIPPON STEEL & SUMITOMO METAL CORPORATION) 27 October 2016 (2016-10-27)<br>  See paragraphs [0053]-[0065] and claims 1-4. | 1-18 |

☑ Further documents are listed in the continuation of Box C.          ☑ See patent family annex.

| | |
| --- | --- |
| *    Special categories of cited documents:<br>"A"  document defining the general state of the art which is not considered to be of particular relevance<br>"D"  document cited by the applicant in the international application<br>"E"  earlier application or patent but published on or after the international filing date<br>"L"   document which may throw doubts on priority claim(s) or which is cited to establish the publication date of another citation or other special reason (as specified)<br>"O"  document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"  document member of the same patent family |
| Date of the actual completion of the international search<br><br>**23 March 2023** | Date of mailing of the international search report<br><br>**24 March 2023** |
| Name and mailing address of the ISA/KR<br><br>**Korean Intellectual Property Office<br>Government Complex-Daejeon Building 4, 189 Cheongsa-ro, Seo-gu, Daejeon 35208** | Authorized officer |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2022/020884** |

**C.    DOCUMENTS CONSIDERED TO BE RELEVANT**

| Category* | Citation of document, with indication, where appropriate, of the relevant passages | Relevant to claim No. |
| --- | --- | --- |
| A | SUZUKI, Hiroshi et al. Mechanism of magnetic domain refinement on grain-oriented silicon steel by laser irradiation. Materials Science Research International. 2002 (publication), vol. 8, no. 4, pp. 207-212. <br> See abstract; pages 210-212; and figures 6-11. | 1-18 |

**INTERNATIONAL SEARCH REPORT**
Information on patent family members

International application No.

**PCT/KR2022/020884**

| Patent document cited in search report | | | Publication date (day/month/year) | Patent family member(s) | | | Publication date (day/month/year) |
|---|---|---|---|---|---|---|---|
| KR | 10-2020-0076508 | A | 29 June 2020 | CN | 113196422 | A | 30 July 2021 |
| | | | | EP | 3901971 | A1 | 27 October 2021 |
| | | | | JP | 2022-515236 | A | 17 February 2022 |
| | | | | KR | 10-2162984 | B1 | 07 October 2020 |
| | | | | US | 2022-0051837 | A1 | 17 February 2022 |
| | | | | WO | 2020-130645 | A1 | 25 June 2020 |
| JP | 11-087122 | A | 30 March 1999 | None | | | |
| KR | 10-2021-0079129 | A | 29 June 2021 | CN | 114829638 | A | 29 July 2022 |
| | | | | EP | 4079878 | A1 | 26 October 2022 |
| | | | | KR | 10-2276850 | B1 | 12 July 2021 |
| | | | | WO | 2021-125680 | A1 | 24 June 2021 |
| WO | 2016-171129 | A1 | 27 October 2016 | BR | 112017019141 | A2 | 02 May 2018 |
| | | | | CN | 107406903 | A | 28 November 2017 |
| | | | | EP | 3287532 | A1 | 28 February 2018 |
| | | | | JP | 6575592 | B2 | 18 September 2019 |
| | | | | KR | 10-2008-600 | B1 | 07 August 2019 |
| | | | | KR | 10-20170122819 | A | 06 November 2017 |
| | | | | RU | 2678351 | C1 | 28 January 2019 |
| | | | | US | 10906134 | B2 | 02 February 2021 |
| | | | | US | 2018-0036838 | A1 | 08 February 2018 |

Form PCT/ISA/210 (patent family annex) (July 2022)